# EUROPEAN PATENT APPLICATION

(11) **EP 4 484 496 A1**
(43) Date of publication of application: **01.01.2025**
(21) Application number: 23760022.6
(22) Date of filing: 22.02.2023
(51) Int. Cl.: C08L 45/00, C08J 3/21, C08J 5/18, C08K 3/16, C08K 5/17, C08L 53/02, C09K 11/02, H01L 29/06

(54) **COMPOSITION, METHOD FOR PRODUCING SAME, FILM CONTAINING COMPOSITION, USE THEREOF, AND METHOD FOR PRODUCING SAME**

(30) Priority: 25.02.2022 JP 2022027935
(71) Applicant: Zeon Corporation, Tokyo 100-8246 (JP)
(72) Inventor: KASHIWAGI, Motofumi, Tokyo 100-8246 (JP); MASUHARA, Akito, Yonezawa-shi, Yamagata 992-8510 (JP)
(74) Representative: Maiwald GmbH
(86) International application number: PCT/JP2023/006406
(87) International publication number: WO 2023/163023

(57) **Abstract**

Provided is a composition including a quantum dot material having a perovskite-type crystal structure; and an olefin polymer. Preferably the olefin polymer is a cyclic olefin-based polymer, or a block copolymer including a repeating unit derived from an aromatic vinyl compound, and a repeating unit derived from a chain conjugated diene compound. Also provided are a film including the composition, a light-emitting device and a display body using the film as a light conversion element, a power generation device using the film as a power generation element, as well as production methods for the composition and the film.

## Description

### Field

The present invention relates to a composition including a quantum dot material having a perovskite-type crystal structure and a method for producing the composition, as well as a film including the composition, a use of the film, and a method for producing the film.

### Background

A quantum dot material is a nano-size semiconductor material that exhibits a quantum effect caused by confining electrons in quantum dots. Progress is being made on the use of the quantum dot material as a material for a light-emitting device, for example, as described in Patent literature 1 (Patent literature 1). Furthermore, progress is also being made on the use of the quantum dot material as a material for, for example, a power generation device.

### Citation List

### Patent Literature

Patent Literature 1: International Publication No. 2012/102107 (corresponding publication: U.S. Patent Application Publication No. 2013/0334557)

### Summary

### Technical Problem

In recent years, as the quantum dot material, a quantum dot material with a perovskite-type crystal structure is attracting attention. The quantum dot material described above has a high photoluminescence quantum yield (luminous efficiency) and a high photoelectric conversion efficiency and is thus expected to be used as a material for a power generation device and a light-emitting device.

On the other hand, the quantum dot material with a perovskite-type crystal structure has low atmospheric stability.

The present invention has been made in view of the above-mentioned circumstances, and an object of the present invention is to provide a composition that includes a quantum dot material having a perovskite crystal-type structure and that is capable of making the atmospheric stability of the quantum dot material favorable, and also to provide a method for producing the composition, as well as a film including the composition and a method for producing the film.

### Solution to Problem

The present inventors have discovered that, when a quantum dot material having a perovskite-type crystal structure is used in combination with an olefin polymer in a composition, it is possible to improve the atmospheric stability of the quantum dot material in the composition and in an article such as a film formed from the composition, thereby completing the present invention. The present invention includes the following.
(1) A composition comprising:
   a quantum dot material having a perovskite-type crystal structure; and
   an olefin polymer.
(2) The composition according to (1), wherein the olefin polymer includes a cyclic olefin-based polymer.
(3) The composition according to (2), wherein:
   the cyclic olefin-based polymer includes a norbornene-based polymer; and
   the norbornene-based polymer includes at least one type selected from a hydrogenated product of a ring-opening polymer of a monomer having a norbornene structure, and an addition copolymer of a monomer having a norbornene structure and an α-olefin and a hydrogenated product of the addition copolymer.
(4) The composition according to (2), wherein:
   the cyclic olefin-based polymer includes a hydrogenated block copolymer [E]; and
   the hydrogenated block copolymer [E] is a hydrogenated block copolymer obtained by hydrogenating a block copolymer [D], the block copolymer [D] including
      a polymer block [A] containing, as a main component, a repeating unit [I] derived from an aromatic vinyl compound, and
      a polymer block [B] or a polymer block [C], the polymer block [B] containing, as main components, the repeating unit [I] derived from an aromatic vinyl compound and a repeating unit [II] derived from a chain conjugated diene compound, the polymer block [C] containing, as a main component, the repeating unit [II] derived from a chain conjugated diene compound.
(5) The composition according to (4), wherein the cyclic olefin-based polymer contains an alkoxysilyl group.
(6) The composition according to (1), wherein the olefin polymer includes a block copolymer [D], the block copolymer [D] including
   a polymer block [A] containing, as a main component, a repeating unit [I] derived from an aromatic vinyl compound, and
   a polymer block [B] or a polymer block [C], the polymer block [B] containing, as main components, the repeating unit [I] derived from an aromatic vinyl compound and a repeating unit [II] derived from a chain conjugated diene compound, the polymer block [C] containing, as a main component, the repeating unit [II] derived from a chain conjugated diene compound.
(7) The composition according to any one of (1) to (6), wherein an amount of the quantum dot material included in the composition is 0.05 part by weight or more and 50 parts by weight or less relative to 100 parts by weight of the olefin polymer.
(8) A film comprising the composition according to any one of (1) to (7).
(9) A light-emitting device using the film according to (8) as a light conversion element.
(10) A power generation device using the film according to (8) as a power generation element.
(11) A display body using the film according to (8) as a light conversion element.
(12) A method for producing the composition according to any one of (1) to (7), the method comprising:
   a first step of obtaining a dispersion liquid of the quantum dot material;
   a second step of obtaining a solution of the olefin polymer; and
   a third step of mixing the dispersion liquid of the quantum dot material and the solution of the olefin polymer.
(13) A method for producing the composition according to any one of (1) to (7), the method comprising:
   a first step of obtaining a dispersion liquid of the quantum dot material; and
   a fourth step of adding the olefin polymer to the dispersion liquid and dissolving the polymer in the dispersion liquid.
(14) A method for producing a film using the composition according to any one of (1) to (7), the method comprising:
   a fifth step of forming a composition layer using the composition; and
   a sixth step of drying the composition layer.
(15) The method for producing a film according to (14), wherein:
   the fifth step is a step of forming the composition layer by applying the composition onto a substrate; and
   the application of the composition is performed using a die coater, a gravure coater, a comma coater, a knife coater, or inkjet.

### Advantageous Effects of Invention

According to the present invention, it is possible to provide a composition including a quantum dot material having a perovskite-type crystal structure that is capable of improving an atmospheric stability of the quantum dot material, and a method for producing the composition, as well as a film including the composition and a method for producing the film.

### Brief Description of Drawings

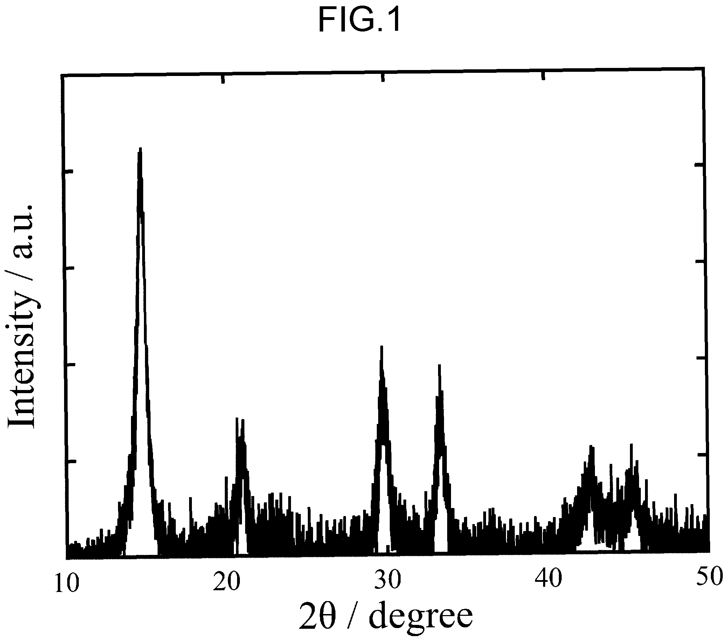

FIG. 1 is an X-ray diffraction pattern of FAPbBr₃ obtained in Example 1.

### Description of Embodiments

Hereinafter, the present invention will be described in detail with reference to embodiments and examples. However, the present invention is not limited to embodiments and examples described below, and may be freely modified for implementation without departing from the scope of claims of the present invention and the scope of their equivalents.

For convenience of explanation, the term "solvent" in the following description encompasses not only a medium in a solution, but also a dispersing medium in which a solid is dispersed.

In the following description, a "plate," "layer," and "film" may be rigid members or flexible members, such as a plastic film, unless otherwise specified.

### [1. Composition]

A composition of an embodiment of the present invention includes a quantum dot material having a perovskite-type crystal structure and an olefin polymer.

According to the present invention, when the specific quantum dot material and the specific polymer described above are combined, it is possible to obtain the composition in which the quantum dot material has good atmospheric stability. Furthermore, when this composition is used, it is possible to obtain an article such as a film in which the quantum dot material has good atmospheric stability.

### [1.1. Quantum dot material]

The quantum dot material is a nano-size semiconductor material that exhibits a quantum effect caused by confining electrons in quantum dots. Furthermore, the quantum dot material functions as a fluorophore that absorbs light of a specific wavelength as excitation light and emits fluorescence of another wavelength. In the quantum dot material, an exciton (electron) generated by light absorption is confined in a nano-size region, resulting in restriction of the movement of the exciton. As a result, a quantum effect where the energy level becomes discrete is caused. Furthermore, the resulting bandgap is changed depending on the particle size of the quantum dot material. As a result, the quantum dot material has a property that the wavelength of fluorescence emission can be altered by the particle size.

The wavelength of the excitation light of the quantum dot material used in the present embodiment may be, for example, 300 nm or more and 800 nm or less. Furthermore, the wavelength of the fluorescence of the quantum dot material may be, for example, in the visible light region (e.g., 400 nm or more and 750 nm).

The quantum dot material according to the present embodiment has a perovskite-type crystal structure. A term "perovskite-type crystal structure" is a type of crystal structure, and this term refers to the same crystal structure as that of perovskite (CaTiO₃). For example, if, in the perovskite-type crystal structure, respective sites of the crystal structure are represented by A', B', and X', the perovskite-type crystal structure ideally has a cubic unit cell of a cubic crystal system, where A' is located at each corner of the cubic crystal, B' is located at the body-center position, and X's are located at face centered positions of the cubic crystal with B' as the center. Such a structure is expressed as A'B'X'₃ in the formula.

The quantum dot material having the perovskite-type crystal structure is preferably, for example, a material represented by the following composition formula (1) :

A₍₁₊ₐ₎B_{(1+b)}X_{(3+c)} (1)

(in the above-mentioned composition formula (1), A represents a monovalent cation, B represents a divalent metal ion, X represents a monovalent anion, "a" satisfies - 0.2 ≤ a ≤ 0.2, "b" satisfies -0.2 ≤ b ≤ 0.2, and "c" satisfies -0.5 ≤ a ≤ 0.5).

In the above-mentioned composition formula (1), A represents a monovalent cation. A is usually located at the A' sites in the perovskite-type crystal structure. Examples of A may include a methyl ammonium (MA) ion, a formamidinium (FA) ion, and a cesium (Cs) ion.

In the above-mentioned composition formula (1), B represents a divalent metal ion. B is usually located at the B' site in the perovskite-type crystal structure. Examples of B may include Pb.

In the composition formula (1), X represents a monovalent anion. X is usually located at the X' sites in the perovskite-type crystal structure. Examples of X may include Cl, Br, and I. In the quantum dot material represented by the composition formula (1), the color of the fluorescent light emitted from the quantum dot material may be adjusted by the anion represented by X. Specifically, when Cl is used, a quantum dot material emitting blue fluorescence may be formed. When Br is used, a quantum dot material emitting green fluorescence may be formed. When I is used, a quantum dot material emitting red fluorescence may be formed.

In the above-mentioned composition formula (1), "a" usually satisfies -0.2 ≤ a ≤ 0.2, preferably -0.1 ≤ a ≤ 0.1, ideally a = 0. Furthermore, "b" usually satisfies - 0.2 ≤ b ≤ 0.2, preferably -0.1 ≤ b ≤ 0.1, ideally b = 0. Furthermore, b usually satisfies -0.2 ≤ b ≤ 0.2, preferably -0.1 ≤ b ≤ 0.1, ideally b = 0. Furthermore, c satisfies - 0.5 ≤ c ≤ 0.5, preferably -0.3 ≤ c ≤ 0.3, ideally c = 0. In the present embodiment, it is preferable that the above-mentioned composition formula (I) satisfies a = b = c = 0, that is, the quantum dot material has a composition represented by ABX₃.

As a more specific example of the quantum dot material, FAPbBr₃ may be mentioned as a material exhibiting green fluorescence. Furthermore, for example, CsPbCl₃, MAPbCl₃, and FAPbCl₃ may be mentioned as materials exhibiting blue fluorescence. Furthermore, for example, CsPbI₃, MAPbI₃, and FAPbI₃ may be mentioned as materials exhibiting red fluorescence.

Whether the quantum dot material has the perovskite-type crystal structure may be confirmed by, for example, a spectrum obtained by powder X-ray diffraction (XRD) measurement. Specifically, if such a spectrum has spectrum peaks of a known quantum dot material having a perovskite-type crystal structure, it may be confirmed that the quantum dot material has the perovskite-type crystal structure. For example, when the quantum dot material includes FA, Pb, and Br, whether such a quantum dot material has the perovskite-type crystal structure may be confirmed by examining the presence or absence of peaks at positions of 20 = 14.7°, 21.4°, 29.8°, 33.3°, 42.6°, and 45.4° in the powder X-ray diffraction using CuKα radiation. Each peak position may include an error within a range of, for example, ±0.5°.

The average particle size of the quantum dot material may be appropriately selected depending on the desired fluorescent color. The average particle size is preferably 1 nm or more, more preferably 3 nm or more, and preferably 20 nm or less, more preferably 10 nm or less.

The average particle size of the quantum dot material may be determined by observing the quantum dot material using a transmission electron microscope (TEM).

In this method, the sizes of 30 randomly selected particles may be measured, and the arithmetic average value of the measurement results may be taken as the average particle size.

The weight ratio of the quantum dot material included in the composition may be appropriately selected depending on the use of the composition, and the weight ratio is preferably 0.05 part by weight or more, more preferably 0.5 part by weight or more, still more preferably 1 part by weight or more, and is preferably 50 parts by weight or less, more preferably 40 parts by weight or less, still more preferably 30 parts by weight or less, relative to 100 parts by weight of the olefin polymer. The reason for the above-mentioned range is that when the weight ratio of the quantum dot material falls within the above-mentioned range, the quantum dot material can be well dispersed in the composition.

### [1.2. Olefin polymer]

The olefin polymer may be a polymer that is obtainable by polymerization of an olefin monomer or a hydrogenated product thereof. The olefin polymer may be not only a homopolymer but also a copolymer, and may be a hydrogenated product of the copolymer. Examples of the olefin polymer may include a chain olefin-based polymer which is a polymer containing a chain olefin unit; and a cyclic olefin-based polymer containing a cyclic olefin monomer unit. Among these, the olefin polymer is preferably a cyclic olefin-based polymer because the cyclic olefin-based polymer has high heat resistance and excellent hygroscopicity. The cyclic olefin-based polymer is also referred to as a cycloolefin-based polymer.

The cyclic olefin-based polymer may have a cyclic structure in its molecule. Usually, a cyclic olefin-based polymer has an alicyclic structure in the repeating unit of the polymer. The cyclic olefin-based polymer may be a polymer having an alicyclic structure in a main chain, a polymer having an alicyclic structure in a side chain, a polymer having an alicyclic structure in a main chain and a side chain, or a mixture of two or more of these at any ratio. The cyclic olefin-based polymer is preferably a polymer containing an alicyclic structure in its main chain from the viewpoint of mechanical strength, heat resistance, and the like.

Examples of the alicyclic structure may include a saturated alicyclic hydrocarbon (cycloalkane) structure and an unsaturated alicyclic hydrocarbon (cycloalkene, cycloalkyne) structure. Among these, a cycloalkane structure and a cycloalkene structure are preferable from the viewpoint of mechanical strength, heat resistance, and the like. Among these, a cycloalkane structure is particularly preferable.

The number of carbon atoms constituting the alicyclic structure per alicyclic structure is preferably in the range of 4 or more, more preferably 5 or more, and preferably 30 or less, more preferably 20 or less, and particularly preferably 15 or less. When the number of carbon atoms falls within this range, mechanical strength, heat resistance, and moldability of a substrate layer are highly balanced and thus this range is preferable.

In the cyclic olefin-based polymer, the ratio of structural units having an alicyclic structure relative to all the structural units may be appropriately selected depending on the purpose of use. The ratio is preferably 55% by weight or more, more preferably 70% by weight or more, and still more preferably 90% by weight or more. When the ratio of structural units having an alicyclic structure to all the structural units falls within this range, it is preferable from the viewpoint of transparency and heat resistance of the substrate layer.

Examples of the cyclic olefin-based polymer may include a norbornene-based polymer; a monocyclic cyclic olefin-based polymer, a cyclic conjugated diene-based polymer, a vinyl alicyclic hydrocarbon-based polymer, and hydrogenated products thereof; and a hydrogenated product of a vinyl aromatic hydrocarbon polymer. Among these, one or more types selected from the group consisting of a norbornene-based polymer; a vinyl alicyclic hydrocarbon-based polymer and a hydrogenated product thereof; and a hydrogenated product of a vinyl aromatic hydrocarbon polymer are more preferable because of their good transparency.

Examples of the norbornene-based polymer may include a ring-opening polymer of a monomer having a norbornene structure and a hydrogenated product thereof; and an addition polymer of a monomer having a norbornene structure and a hydrogenated product thereof. Examples of the ring-opening polymer of a monomer having a norbornene structure may include a ring-opening homopolymer of one type of monomer having a norbornene structure, a ring-opening copolymer of two or more types of monomers having a norbornene structure, and a ring-opening copolymer of a monomer having a norbornene structure and an optional monomer copolymerizable therewith. Furthermore, examples of the addition polymer of a monomer having a norbornene structure may include an addition homopolymer of one type of monomer having a norbornene structure, an addition copolymer of two or more types of monomers having a norbornene structure, and an addition copolymer of a monomer having a norbornene structure and an optional monomer copolymerizable therewith. Among these, a hydrogenated product of a ring-opening polymer of a monomer having a norbornene structure, an addition copolymer of a monomer having a norbornene structure and an α-olefin, and a hydrogenated product of the addition copolymer of a monomer having a norbornene structure and an α-olefin are preferable. A hydrogenated product of a ring-opening copolymer of two or more types of monomers having a norbornene structure, an addition copolymer of a monomer having a norbornene structure and an α-olefin, and a hydrogenated product of the addition copolymer of a monomer having a norbornene structure and an α-olefin are more preferable.

Examples of the monomer having a norbornene structure may include bicyclo[2.2.1]hept-2-ene (trivial name: norbornene), tricyclo[4.3.0.1^{2,5}]deca-3,7-diene (trivial name: dicyclopentadiene), 7,8-benzotricyclo[4.3.0.1².⁵]dec-3-ene (trivial name: methanotetrahydrofluorene), tetracyclo[4.4.0.1^{2,5}.1^{7,10}]dodeca-3-ene (trivial name: tetracyclododecene), and derivatives of these compounds (for example, those with a substituent on the ring). Examples of the substituent may include an alkyl group, an alkylene group, and a polar group. These substituents may be the same as or different from each other, and a plurality of these substituents may be bonded to the ring. As the monomer having a norbornene structure, one type thereof may be solely used, and two or more types thereof may also be used in combination at any ratio.

Examples of the types of polar groups may include a heteroatom, and an atomic group having a heteroatom. Examples of the heteroatom may include an oxygen atom, a nitrogen atom, a sulfur atom, a silicon atom, and a halogen atom. Specific examples of the polar group may include a carboxyl group, a carbonyloxycarbonyl group, an epoxy group, a hydroxyl group, an oxy group, an ester group, a silanol group, a silyl group, an amino group, a nitrile group, and a sulfonic acid group.

Examples of the monomer that is ring-opening copolymerizable with the monomer having a norbornene structure may include monocyclic olefins such as cyclohexene, cycloheptene, and cyclooctene, and derivatives thereof; and cyclic conjugated dienes such as cyclohexadiene and cycloheptadiene, and derivatives thereof. As the monomer that is ring-opening copolymerizable with the monomer having a norbornene structure, one type thereof may be solely used, and two or more types thereof may also be used in combination at any ratio.

The ring-opening polymer of the monomer having a norbornene structure may be produced by, for example, polymerizing or copolymerizing the monomer in the presence of a ring-opening polymerization catalyst.

Examples of the α-olefin in the addition copolymer of the monomer having a norbornene structure and the α-olefin may include α-olefins of 2 to 20 carbon atoms such as ethylene, propylene, and 1-butene, and derivatives thereof. Among these, ethylene is preferable. As the α-olefin, one type thereof may be solely used, and two or more types thereof may also be used in combination at any ratio.

The addition polymer of the monomer having a norbornene structure may be produced by, for example, polymerizing or copolymerizing the monomer in the presence of an addition polymerization catalyst.

The above-mentioned hydrogenated products of the ring-opening polymer and the addition polymer may be produced by, for example, hydrogenating an unsaturated carbon-carbon bond, preferably 90% or more thereof, in a solution of the ring-opening polymer and the addition polymer in the presence of a hydrogenation catalyst containing a transition metal such as nickel, palladium, or the like.

Examples of the trade name of the norbornene-based polymer may include "ZEONOR" and "ZEONEX" manufactured by ZEON Corporation, "ARTON" manufactured by JSR Corp., and "APEL" manufactured by Mitsui Chemicals Inc.

Examples of the vinyl alicyclic hydrocarbon-based polymer may include polymers of vinyl alicyclic hydrocarbon-based monomers such as vinylcyclohexene and vinylcyclohexane and hydrogenated products thereof; and hydrogenated products of polymers of vinyl aromatic-based monomers obtained by hydrogenation at aromatic ring portions thereof. Furthermore, examples of the vinyl alicyclic hydrocarbon-based polymer may include a copolymer of a vinyl alicyclic hydrocarbon-based monomer or a vinyl aromatic-based monomer and another monomer copolymerizable with these monomers. Examples of such a copolymer may include a random copolymer and a block copolymer. Examples of such a block copolymer may include, but are not particularly limited to, a diblock copolymer, a triblock copolymer, a multiblock copolymer of more than three blocks, and a gradient block copolymer.

As the vinyl alicyclic hydrocarbon-based polymer, a hydrogenated product of a vinyl aromatic hydrocarbon polymer is preferable. The vinyl aromatic hydrocarbon polymer means a polymer containing a repeating unit [I] derived from an aromatic vinyl compound. The repeating unit derived from an aromatic vinyl compound means a repeating unit having a structure obtained by polymerizing an aromatic vinyl compound. However, the polymer and its constituent unit are not limited by their producing methods.

Examples of the aromatic vinyl compound corresponding to the repeating unit [I] may include styrene; styrene compounds having an alkyl group of 1 to 6 carbon atoms as a substituent such as α-methylstyrene, 2-methylstyrene, 3-methylstyrene, 4-methylstyrene, 2,4-dimethylstyrene, 2,4-diisopropylstyrene, 4-t-butylstyrene, and 5-t-butyl-2-methylstyrene; styrene compounds having a halogen atom as a substituent such as 4-chlorostyrene, dichlorostyrene, and 4-monofluorostyrene; styrene compounds having an alkoxy group of 1 to 6 carbon atoms as a substituent such as 4-methoxystyrene; styrene compounds having an aryl group as a substituent such as 4-phenylstyrene; and vinylnaphthalene compounds such as 1-vinylnaphthalene and 2-vinylnaphthalene. As these compounds, one type thereof may be solely used, and two or more types thereof may also be used in combination at any ratio. Among these, an aromatic vinyl compound which does not include a polar group such as styrene and styrene compounds having an alkyl group of 1 to 6 carbon atoms as a substituent is preferable because therewith hygroscopicity can be lowered, and styrene is particularly preferable from the viewpoint of easy industrial availability.

The polymer containing the repeating unit [I] derived from the aromatic vinyl compound is preferably a specific block copolymer [D]. The block copolymer [D] is a block copolymer composed of a polymer block [A], and any of a polymer block [B] and a polymer block [C]. The polymer block [A] is a polymer block containing, as a main component, a repeating unit [I] derived from an aromatic vinyl compound. The polymer block [B] is a polymer block containing, as main components, the repeating unit [I] derived from an aromatic vinyl compound and a repeating unit [II] derived from a chain conjugated diene compound. The polymer block [C] is a polymer block containing, as a main component, the repeating unit [II] derived from a chain conjugated diene compound. Here, the "main component" refers to a component occupying 50% by weight or more in the polymer block. The proportion of the main component in the polymer block is preferably 80% by weight or more, more preferably 90% by weight or more, and even more preferably 100% by weight. The repeating unit derived from a chain conjugated diene compound means a repeating unit having a structure obtained by polymerizing a chain conjugated diene compound.

Examples of the chain conjugated diene compound corresponding to the repeating unit [II] may include 1,3-butadiene, isoprene, 2,3-dimethyl-1,3-butadiene, and 1,3-pentadiene. As these compounds, one type thereof may be solely used, and two or more types thereof may also be used in combination at any ratio. The chain conjugated diene compound may be linear or branched.

The hydrogenated product of the vinyl aromatic hydrocarbon polymer is a hydrogenated product of a polymer containing the repeating unit [I] derived from an aromatic vinyl compound. The hydrogenated product of the polymer containing the repeating unit [I] derived from an aromatic vinyl compound is preferably a specific block copolymer hydrogenated product [E]. The block copolymer hydrogenated product [E] is a hydrogenated product of the block copolymer [D] described above.

The hydrogenated product of the vinyl aromatic hydrocarbon polymer is a substance obtained by hydrogenating an unsaturated bond of the vinyl aromatic hydrocarbon polymer. Herein, the unsaturated bond of the vinyl aromatic hydrocarbon polymer to be hydrogenated includes both the carbon-carbon unsaturated bond of the main chain and the side chain of the polymer and the carbon-carbon unsaturated bond of the aromatic ring.

The hydrogenated product may be produced by, for example, hydrogenating the unsaturated bonds of the polymer, preferably 90% or more thereof, in a solution of a vinyl aromatic hydrocarbon polymer in the presence of a hydrogenation catalyst containing a transition metal such as nickel, palladium, or the like.

Additional examples of polymers that may be used as the cyclic olefin polymer may include a polymer containing a silicon atom-containing polar group. Examples of such a polymer may include a modified product of the above-mentioned hydrogenated product of the vinyl aromatic hydrocarbon polymer with a silicon atom-containing polar group. When a polymer containing a silicon atom-containing polar group is used as the olefin polymer, adhesion between a member using the composition and another member (for example, a substrate) can be increased.

Hereinafter, the polymer used in the reaction for obtaining the modified product may be referred to as a "pre-reaction polymer" as appropriate. The modified product may have a structure obtained by, for example, graft polymerization of a pre-reaction polymer and a compound having a silicon atom-containing polar group as a monomer. However, the modified product is not limited by the production method. The silicon atom-containing polar group is preferably an alkoxysilyl group.

As examples of compounds having a silicon atom-containing polar group that may be used as a monomer for graft polymerization, examples of compounds having an alkoxysilyl group may include ethylenically unsaturated silane compounds having an alkoxysilyl group such as vinyltrimethoxysilane, vinyltriethoxysilane, allyltrimethoxysilane, allyltriethoxysilane, dimethoxymethylvinylsilane, diethoxymethylvinylsilane, p-styryltrimethoxysilane, p-styryltriethoxysilane, 3-methacryloxypropyltrimethoxysilane, 3-methacryloxypropylmethyldimethoxysilane, 3-methacryloxypropyltriethoxysilane, 3-methacryloxypropylmethyldiethoxysilane, 3-acryloxypropyltrimethoxysilane, 3-acryloxypropyltriethoxysilane, and 2-norbornen-5-yltrimethoxysilane.

By the reaction of the pre-reaction polymer with a compound having a silicon atom-containing polar group, the silicon atom-containing polar group can be introduced into the pre-reaction polymer to obtain a modified product having the silicon atom-containing polar group. When an alkoxysilyl group is introduced as the silicon atom-containing polar group, the amount of the alkoxysilyl group introduced is preferably 0.1 part by weight or more, more preferably 0.2 part by weight or more, and still more preferably 0.3 part by weight or more, and is preferably 10 parts by weight or less, more preferably 5 parts by weight or less, and still more preferably 3 parts by weight or less, relative to 100 parts by weight of the pre-reaction polymer. When the amount of the alkoxysilyl group introduced falls within the above-mentioned range, an excessive elevation of crosslinking degree between alkoxysilyl groups that have been decomposed by moisture can be suppressed, so that a high degree of adhesion can be maintained. Examples of substances having an alkoxysilyl group used for introduction of an alkoxysilyl group and modification methods may include those described in International Publication No. 2015/099079.

The amount of polar groups introduced may be measured by ¹H-NMR spectrometry. In the measurement of the amount of polar groups introduced, when the amount introduced is small, the measurement may be performed with an increased number of times of integration.

Introduction of an alkoxysilyl group as a polar group into the pre-reaction polymer is called silane modification. In silane modification, the alkoxysilyl group may be directly bonded to the pre-reaction polymer, or may be bonded via a divalent organic group such as an alkylene group. Hereinafter, the polymer obtained by silane modification of the pre-reaction polymer is also referred to as a "silane-modified polymer".

The silane-modified polymer is preferably at least one polymer selected from a silane-modified product of a hydrogenated styrene-butadiene block copolymer, a silane-modified product of a hydrogenated styrene-butadiene-styrene block copolymer, a silane-modified product of a hydrogenated styrene-isoprene block copolymer, and a silane-modified product of a hydrogenated styrene-isoprene-styrene block copolymer.

Preferable examples of the olefin polymer other than the cyclic olefin polymer may include a polymer containing a repeating unit derived from a chain conjugated diene compound, and a copolymer containing a repeating unit derived from a chain conjugated diene compound and other repeating units. A more specific example thereof may be a polymer containing the repeating unit [I] derived from an aromatic vinyl compound such as the block copolymer [D] described above.

The weight-average molecular weight Mw of the olefin polymer is preferably 10,000 or more, more preferably 15,000 or more, and particularly preferably 20,000 or more, and is preferably 100,000 or less, more preferably 80,000 or less, and particularly preferably 50,000 or less. When the weight-average molecular weight falls within such a range, mechanical strength and moldability of the olefin polymer are highly balanced.

The molecular weight distribution (Mw/Mn) of the olefin polymer is preferably 1.2 or more, more preferably 1.5 or more, and particularly preferably 1.8 or more, and is preferably 3.5 or less, more preferably 3.0 or less, and particularly preferably 2.7 or less. Herein, Mn represents a number-average molecular weight. By setting the molecular weight distribution to be equal to or higher than the lower limit value of the above-mentioned range, productivity for producing the olefin polymer can be increased, and the production cost therefor can be suppressed. When the molecular weight distribution is equal to or lower than the upper limit value, the amount of the low molecular component is reduced. As a result, relaxation of the layer of the composition during high-temperature exposure can be suppressed, and the stability of the layer can be enhanced.

The weight-average molecular weight (Mw) and number-average molecular weight (Mn) may be measured using gel-permeation chromatography (GPC). Solvents used for GPC may include cyclohexane, toluene, and tetrahydrofuran. When GPC is used, the weight-average molecular weight is measured, for example, as a polyisoprene-equivalent or polystyrene-equivalent relative molecular weight.

The weight ratio (containing amount) of the olefin polymer in the composition may be appropriately selected depending on the use of the composition, and is preferably 5% by weight or more, and more preferably 10% by weight or more, and is preferably 50% by weight or less, and more preferably 40% by weight or less.

### [1.3. Optional components]

The composition according to the present embodiment may contain an optional component in addition to the quantum dot material and the olefin polymer described above. Examples of the optional components may include a solvent.

The solvent contained in the composition is preferably a non-polar solvent. Examples of the non-polar solvent may include xylene, toluene, hexane, cyclohexane, ethylcyclohexane, and decalin. As the solvent, one type thereof may be solely used, and two or more types thereof may also be used in combination.

The weight ratio (containing amount) of the solvent in the composition may be appropriately selected depending on the use of the composition.

### [2. Film]

A film according to an embodiment of the present invention includes the above-mentioned composition. However, the film usually does not contain a solvent, or, even if it does, contains a solvent in an amount of an inevitable degree in the light of the production process of the film.

According to the present invention, since the film includes the above-mentioned composition, it is possible to obtain a film in which the quantum dot material has good atmospheric stability. In addition, thereby a decrease in the function imparted to the film by the quantum dot material can be reduced.

The thickness of the film is appropriately selected depending on the use and is not particularly limited. For example, the thickness is 10 µm or more and 1000 µm or less.

The film according to the present embodiment may be configured to have only a film layer containing the composition described above, or may be configured to have a structure in which a film layer containing the composition described above is disposed on a substrate as a support. Examples of the material of the substrate may include a resin and glass.

The film according to the present embodiment may further include an optional layer such as a barrier layer or a light scattering layer in addition to the film layer containing the above-mentioned composition.

### [3. Light-emitting device]

A light-emitting device according to an embodiment of the present invention is a light-emitting device using the above-mentioned film as a light conversion element.

According to the present invention, by the use of the above-mentioned film as the light conversion element, it is possible to obtain a light-emitting device having a good luminous efficiency and in which deterioration over time of this luminous efficiency is suppressed.

The light-emitting device usually includes a light source and a light conversion element, and part of the light from the light source is transmitted through the light conversion element to undergo wavelength conversion.

The light source is not limited as long as it can emit light with a wavelength that is available as excitation light for the quantum dot material. Examples of the light source may include a known light source such as a light-emitting diode (LED) or a laser. Among these, an LED is preferable, and a blue light-emitting diode (blue LED) and an ultraviolet light-emitting diode (ultraviolet LED) are more preferable.

For example, when a blue light-emitting diode is used as the light source, the quantum dot material included in the film preferably includes a quantum dot material that emits red fluorescence and a quantum dot material that emits green fluorescence. Converting part of the blue light from the blue light-emitting diode into red light and green light makes it possible to obtain a light-emitting device that emits white light.

### [4. Power generation device]

A power generation device of an embodiment of the present invention is a power generation device using the above-mentioned film as a power generation element. This power generation device utilizes a semiconductor function of the quantum dot material having the perovskite-type crystal structure, and is referred to as a perovskite-type solar cell. Furthermore, the power generation element is also referred to as an active layer.

According to the present invention, by the use of the above-mentioned film as a power generation element, the atmospheric stability of the quantum dot material in the film can be improved. Thus, it is possible to obtain a power generation device in which the power generation element is prevented from being deteriorated over time.

The power generation device usually includes a first electrode, an electron transport layer, an active layer as a power generation element, a hole transport layer, and a second electrode in this order. In the power generation device, when the active layer is irradiated with light, an electromotive force is generated by electrons flowing through the first electrode and holes flowing through the second electrode. In such a power generation device, the above-mentioned film is usually used as the active layer. The first electrode, the electron transport layer, the hole transport layer, and the second electrode used in the power generation device may be the same as those used in a known power generation device.

### [5. Display body]

A display body of an embodiment of the present invention uses the above-mentioned film as a light conversion element.

According to the present invention, by the use of the above-mentioned film as the light conversion element, it is possible to obtain a display body capable of displaying a clear display image and in which the display quality is prevented from being deteriorated over time.

The display body usually includes a light source, a display panel, and a light conversion element. In a case where the display panel is a self-luminous display panel, the display panel may also function as a light source. Examples of the display panel may include a liquid crystal panel as a display body for a liquid crystal display device, and an organic electroluminescence (EL) panel as a display body for an organic electroluminescence (EL) display device (hereinafter also referred to as an "organic EL display device" as appropriate).

The liquid crystal panel usually includes a liquid crystal cell that includes a liquid crystal and an electrode that can apply a voltage to the liquid crystal. The liquid crystal cell may be of any mode, such as, for example, in-plane switching (IPS) mode, vertical alignment (VA) mode, multi-domain vertical alignment (MVA) mode, continuous spin wheel alignment (CPA) mode, hybrid alignment nematic (HAN) mode, twisted nematic (TN) mode, super twisted nematic (STN) mode, or optically compensated bend (OCB) mode.

In a case where the display panel is a liquid crystal panel, the display panel usually includes a light source as a separate member. The display panel usually includes the light source, a film as a light conversion element, and a liquid crystal panel in this order.

The organic EL panel usually includes an organic EL element that usually includes a transparent electrode layer, a light-emitting layer, and an electrode layer in this order. In this organic EL element, the light-emitting layer can generate light when a voltage is applied from the transparent electrode layer and the electrode layer. Examples of a material constituting the organic light-emitting layer may include a poly(paraphenylenevinylene)-based material, a polyfluorene-based material, and a poly(vinylcarbazole)-based material. Furthermore, the light-emitting layer may have a laminate of a plurality of layers emitting light of different colors, or a mixed layer in which a layer of a certain pigment is doped with a different pigment. Furthermore, the organic EL element may include a functional layer such as a hole injection layer, a hole transport layer, an electron injection layer, an electron transport layer, an equipotential surface forming layer, or an electronic charge generation layer. In a case where the panel is the organic EL panel, a film as the light conversion element is placed on the viewing side of the organic EL panel.

### [6. Method for producing composition]

The method for producing the above-mentioned composition is not particularly limited. For example, it is preferable that the production method includes a first step of obtaining a dispersion liquid of the quantum dot material, a second step of obtaining a solution of the olefin polymer, and a third step of mixing the dispersion liquid of the quantum dot material and the solution of the olefin polymer.

As another example, it is also preferable that the method for producing the above-mentioned composition includes a first step of obtaining a dispersion liquid of the quantum dot material, and a fourth step of adding the above-mentioned olefin polymer to the dispersion liquid and dissolving the above-mentioned polymer in the dispersion liquid.

In the following explanation, the production method including the first step to the third step is referred to as a production method of a first embodiment, and the production method including the first step and the fourth step is referred to as a production method of a second embodiment. The composition according to the present embodiment may include a solvent as an optional component. The compositions obtained by the production methods of the first embodiment and the second embodiment usually include the solvents unless the solvents are removed.

### [6.1. Production method of first embodiment]

The method for producing the composition according to the first embodiment includes the first step of obtaining a dispersion liquid of the quantum dot material, the second step of obtaining a solution of the olefin polymer, and the third step of mixing the dispersion liquid of the quantum dot material and the solution of the olefin polymer.

According to the first embodiment, the dispersion liquid of the quantum dot material and the solution of the olefin polymer are separately prepared and then mixed together so that the quantum dot material can be well dispersed in the mixed liquid. This can improve the dispersibility of the quantum dots in the composition.

### [6.1.1. First step]

The first step according to the first embodiment is a step of obtaining the dispersion liquid of the quantum dot material.

The dispersion liquid usually includes the quantum dot material and a solvent as a dispersion medium. The quantum dot material is the same as described in the section [1. Composition] above.

The preferable solvent is, for example, a nonpolar solvent. The non-polar solvent is the same as described in the section [1. Composition] above. Specifically, the solvent in the first step is preferably a solvent that can dissolve the olefin polymer used in the second step described below.

The concentration of the quantum dot material in the dispersion medium is, for example, 1 kg/m³ (mg/ml) or more, and preferably 2 kg/m³ or more, and is, for example, 20 kg/m³ or less, and preferably 10 kg/m³ or less. This is because when the weight ratio of the quantum dot material falls within the above-mentioned range, the quantum dot material can be well dispersed in the dispersion medium.

In the first step, the dispersion liquid may be obtained by, for example, adding the quantum dot material to the dispersion medium and stirring the mixture using a known stirring method.

### [6.1.2. Second step]

The second step according to the first embodiment is a step of obtaining the solution of the olefin polymer.

The solution usually includes the olefin polymer and a solvent. The olefin polymer and the solvent may be the same as those described in the section [1. Composition] above.

The weight ratio of the olefin polymer in the solution is preferably 5% by weight or more, and more preferably 15% by weight or more, and is preferably 50% by weight or less, and more preferably 45% by weight or less, depending on the molecular weight and composition of the olefin polymer.

In the second step, the solution may be obtained by, for example, adding the quantum dot material to the dispersion medium and stirring the mixture using a known stirring method.

### [6.1.3. Third step]

The third step according to the first embodiment is a step of mixing the dispersion liquid of the quantum dot material and the solution of the olefin polymer.

The mixing amounts of the dispersion liquid of the quantum dot material and the solution of the olefin polymer may be appropriately selected depending on the use of the composition, and, for example, it is preferable to mix the dispersion liquid and the solution so that the weight ratio of the quantum dot material relative to the olefin polymer becomes a desired ratio. A preferable range of the weight ratio of the quantum dot material relative to the olefin polymer may be the same as that described in the section [1. Composition] above.

### [6.2. Production method of second embodiment]

The method for producing the composition according to the second embodiment includes the first step of obtaining a dispersion liquid of the quantum dot material and the fourth step of adding the olefin polymer to the dispersion liquid and dissolving the polymer in the dispersion liquid.

According to the second embodiment, the olefin polymer is directly added and dissolved in the dispersion liquid of the quantum dot material, and thus the composition can be produced with fewer steps.

The solvent used as the dispersion medium in the first step according to the second embodiment is a solvent that can disperse the quantum dot material and dissolve the olefin polymer. Such a solvent may be appropriately selected from the solvents described in the above-mentioned section [1. Composition] depending on the quantum dot material and the olefin polymer. The first step according to the second embodiment may be the same as the first step according to the first embodiment described above.

The fourth step according to the second embodiment is a step of adding the olefin polymer to the dispersion liquid of the quantum dot material and dissolving the olefin polymer in the dispersion liquid of the quantum dot material. In the third step according to the first embodiment, after preparing a solution in which the olefin polymer is dissolved in the solvent in advance, the dispersion liquid of the quantum dot material and the solution of the olefin polymer are dispersed. In the fourth step, the olefin polymer is added to the dispersion liquid of the quantum dot material and dissolved in the dispersion medium (solvent), thereby mixing the quantum dot material and the olefin polymer. In the fourth step, for example, it is preferable that the dissolution of the olefin polymer is promoted by stirring the mixture after the olefin polymer is added to the dispersion liquid of the quantum dot material.

### [7. Film production method]

The method for producing the above-mentioned film is not particularly limited as long as the desired film can be obtained. However, for example, the production method preferably includes a fifth step of forming a composition layer using the composition and a sixth step of drying the above-mentioned composition layer.

### [7.1. Fifth step]

The fifth step is a step of forming the composition layer using the composition.

The method for forming the composition layer is not particularly limited as long as the composition layer having a desired thickness can be obtained. Examples thereof may include a method of applying the composition onto a substrate and a method of filling a mold with the composition, thereby forming the composition layer, with the former method being more preferred.

Examples of the method of applying the composition onto the substrate may include a method of applying the composition using a die coater, a gravure coater, a comma coater, a knife coater, or inkjet.

The thickness of the composition layer may be adjusted as appropriate depending on the solid content concentration in the composition and the desired film thickness.

### [7.2. Sixth step]

The sixth step is a step of drying the composition layer.

The method for drying the composition layer can remove the solvent in the solvent layer.

Any method may be used as the drying method depending on the boiling point of the solvent used. Examples of the drying method may include natural drying, heat drying, reduced pressure drying, and reduced pressure heat drying.

### [Examples]

Hereinafter, the present invention will be specifically described by illustrating Examples. However, the present invention is not limited to the Examples described below. The present invention may be optionally modified for implementation without departing from the scope of claims of the present invention and its equivalents.

In the following description, "%" and "part" representing quantities are on the basis of weight, unless otherwise specified. The following operations were performed at normal temperature and under normal pressure, unless otherwise specified.

### [Evaluation methods]

### [Weight-average molecular weight (Mw) and number-average molecular weight (Mw/Mn)]

The molecular weights of block copolymers and block copolymer hydrogenated products were measured at 38°C as standard polystyrene equivalent values by GPC using THE as an eluent. As a measuring device, "HLC8020GPC" manufactured by Tosoh Corp. was used.

### [Hydrogenation rate]

The hydrogenation rate of the block copolymer hydrogenated products was calculated by measuring the ¹H-NMR spectra of the block copolymer and the block copolymer hydrogenated product.

### [Measurement method of powder X-ray diffraction]

FAPbBr₃ obtained in Example 1 was subjected to powder X-ray diffraction (XRD) measurement using CuKα radiation. For measurement, a sample was placed on a glass cell, and the measurement was performed using an X-ray diffraction device ("MiniFlexII" manufactured by Rigaku Corp.) under the following conditions. Measurement temperature: room temperature (25°C), voltage: 45 kV (CuKα radiation), current: 200 mA, sampling width: 0.01°, scan speed: 0.025°/s, measured diffraction angle range (2θ): 10° to 50°.

### [Measurement method of thickness]

The thickness of the formed film layer was measured five times using a thickness meter (manufactured by Mitutoyo Corp., trade name "ABS DIGIMATIC THICKNESS GAUGE (547-401)"), and the average value of the measured values was taken as the thickness of each film.

### [Atmospheric stability]

The formed film layer (sample) was stored in an environment of 25°C and 50%RH for 30 days or longer. The sample was irradiated with excitation light at a wavelength of 365 nm, and the change in the luminous intensity at a wavelength of 530 nm was determined as the ratio (luminous intensity ratio) of the luminous intensity during storage period relative to the luminous intensity before storage (initial stage). Furthermore, the presence or absence of a shift in the peak position was measured. The measurement was performed using a spectrofluorometer "FP-8050 series" manufactured by JASCO Corp. The results were evaluated using the following criteria.
A: No peak shift from the initial peak position was observed, and the period during which the above-mentioned luminous intensity ratio became 90% or more was 30 days or longer.
B: No peak shift from the initial peak position was observed, and the period during which the above-mentioned luminous intensity ratio became 90% or more was 20 days or longer and shorter than 30 days.
C: A peak shift from the initial peak position to the lower wavelength side was observed. Furthermore, the period during which the above-mentioned luminous intensity ratio became 90% or more was shorter than 20 days, or the above-mentioned luminous intensity ratio was less than 90% throughout the storage period.

### [Dispersibility]

The dispersion liquid of the quantum dot material was added to the polymer solution in which the polymer was dissolved in the organic solvent so that the ratio of the dispersion liquid of the quantum dot material relative to 100 parts of the polymer was 5 parts, 10 parts, 15 parts, 20 parts, 25 parts, or 30 parts (cumulative amount) (the ratio of the quantum dot material relative to 100 parts of the polymer was 0.05 part, 0.11 part, 0.16 part, 0.21 part, 0.26 part, or 0.32 part (cumulative amount)). Each mixed liquid was stirred and then allowed to stand for 24 hours and then the presence or absence of precipitates was observed. The polymer solution and the dispersion liquid of the quantum dot material were the same as those used in each of Examples and Comparative Examples. The results were evaluated using the following criteria.
A: No precipitate was observed even when the quantum dot material was added in an amount of 30 parts or more.
B: Precipitates were observed when the quantum dot material was added in an amount of 20 parts or more and less than 30 parts.
C: Precipitates were observed when the quantum dot material was added in an amount of 15 parts or more and less than 20 parts.
D: Precipitates were observed when the quantum dot material was added in an amount of less than 15 parts.

### [Luminous efficiency (photoluminescence quantum yield)]

The photoluminescence quantum yield of the quantum dot material was measured using a spectrofluorometer "FP-8050 series" manufactured by JASCO Corp. High photoluminescence quantum yield is indicative of high luminous efficiency.

First, toluene for spectrophotometry was put in a quartz cell (with four transparent sides), and a baseline value was measured using the spectrofluorometer described above. Subsequently, the dispersion liquid of the quantum dot material described below was put in the toluene for spectrophotometry in the quartz cell so that the sample absorption rate was 50%, and a sample value was measured using the spectrofluorometer described above. Based on the obtained baseline value and sample value, the photoluminescence quantum yield (PLQY) was measured using quantum yield calculation software that comes with the spectrofluorometer described above. The results were evaluated using the following criteria.
A: Photoluminescence quantum yield of 70% or more
B: Photoluminescence quantum yield of less than 70%

### [Adhesion]

A film layer was formed on a glass substrate according to a method for preparing an evaluation sample, and the obtained film layer was subjected to a cross-cut test specified in JIS K 5600-5-6.

Incisions were made in the obtained film layer in areas of 10 mm × 10 mm with 1 mm intervals to create 100 1-mm squares. A cellophane tape was pasted on the surface of this coated film, and then the cellophane tape was peeled off. The number of squares of the film layer that remained on the glass substrate without being peeled off was counted. The results were evaluated using the following criteria.
A: Peeling was not observed in 90% or more of the film layer.
B: Peeling was not observed in 80% or more and less than 90% of the film layer.
C: Peeling was not observed in 50% or more and less than 80% of the film layer.
D: Peeling was not observed in less than 50% of the film layer.

### [Production Example 1: Production of olefin polymer (SIS)]

The block-copolymer [D1] described below was produced as an olefin polymer by the following steps.

Into a reaction vessel that was equipped with a stirrer and in which the air was sufficiently replaced with nitrogen, 400 parts of dehydrated cyclohexane, 10 parts of dehydrated styrene, and 0.475 part of dibutyl ether were poured. To initiate polymerization, n-butyllithium (150 cyclohexane solution) in an amount of 0.88 part was added thereto while the entirety of the mixture was stirred at 60°C. Subsequently, while the entirety of the mixture was stirred at 60°C, 15 parts of dehydrated styrene were continuously poured into the reaction vessel over 40 minutes to effect progression of the polymerization reaction. After the pouring was completed, the entirety was further stirred at 60°C for 20 minutes. The reaction liquid was measured by gas chromatography (GC), and it was confirmed that the polymerization conversion rate was 99.5% at this point.

Subsequently, 50.0 parts of dehydrated isoprene were continuously added to the reaction liquid over 130 minutes, and stirring was continued for 30 minutes after the addition was completed. At this point, the reaction liquid was analyzed by GC, and it was confirmed that the polymerization conversion rate was 99.5%.

After that, 25.0 parts of dehydrated styrene were further added to the reaction liquid continuously over 70 minutes, and stirring was continued for 60 minutes after the addition was completed. At this point, the reaction liquid was analyzed by GC, and it was confirmed that the polymerization conversion rate was substantially 100%.

Then, 0.5 part of isopropyl alcohol was added to terminate the reaction. As a result, a polymer solution containing a block copolymer [D1] of [A]-[B]-[A] type was obtained. This block copolymer [D1] is a ternary block copolymer consisting of blocks (St) containing a repeating unit derived from styrene and blocks (Ip) containing a repeating unit derived from isoprene. The weight ratio of respective blocks was St : Ip : St = 1:2:1. The weight-average molecular weight (Mw) of the block copolymer [D1] was 40000, and the molecular weight distribution (Mw/Mn) was 1.5.

### [Production Example 2: Production of olefin polymer (HSIS)]

As an olefin polymer, a hydrogenated block copolymer [E1], which is a hydrogenated product of the block copolymer [D1], was produced by the following procedures.

The polymer solution obtained in Production Example 1 was transferred to a pressure-resistant reaction vessel equipped with a stirrer, and 4.0 parts of a diatomaceous earth-supported nickel catalyst (product name "E22U", a nickel-supported amount of 60%, manufactured by JGC Catalysts and Chemicals Ltd.) as a hydrogenation catalyst, and 30 parts of dehydrated cyclohexane were added thereto and mixed. The air inside the reaction vessel was replaced with hydrogen gas. Hydrogen was further supplied while the solution was stirred, and the hydrogenation reaction was performed at a temperature of 190°C and a pressure of 4.5 MPa for 6 hours.

The weight-average molecular weight (Mw) of the block copolymer hydrogenated product [E1] contained in the reaction solution obtained by the hydrogenation reaction was 49,000, and the molecular weight distribution (Mw/Mn) was 1.36.

After completion of the hydrogenation reaction, the reaction solution was filtered to remove the hydrogenation catalyst, and then 2.0 parts of a xylene solution in which 0.1 part of pentaerythritol tetrakis[3-(3,5-di-t-butyl-4-hydroxyphenyl)propionate] (trade name, "Songnox (registered trademark) 1010" manufactured by Songwon Industrial Co., Ltd.) as a phenol-based antioxidant was dissolved were added thereto and dissolved.

Then, a cylindrical concentrate dryer (product name "KONTRO", manufactured by Hitachi, Ltd.) was used to remove cyclohexane, xylene, and other volatile components from the above-mentioned solution at a temperature of 260°C and a pressure of 0.001 MPa or lower. The molten polymer was extruded from a die into a form of strands. After cooling, 95 parts of pellets of the block copolymer hydrogenated product [E1] were produced by a pelletizer.

The obtained hydrogenated block copolymer [E1] had a weight-average molecular weight (Mw) of 47500 and a molecular weight distribution (Mw/Mn) of 1.3. The hydrogenation ratio was 99.8%.

### [Production Example 3: Production of olefin polymer (Si-HSIS)]

An alkoxysilyl group-modified product [S1] of the hydrogenated block copolymer [E1] was produced as an olefin polymer by the following procedures.

Relative to 100 parts of the pellets of the block copolymer hydrogenated product [E1] obtained above, 2 parts by weight of vinyltrimethoxysilane (KBM-1003; manufactured by Shin-Etsu Chemical Co., Ltd.) and 0.1 part by weight of 2,5-dimethyl-2,5-di(t-butylperoxy)hexane (product name "Perhexa (registered trademark) 25B", manufactured by NOF Corporation) were weighed, and the pellets were externally lubricated while stirring in a Henschel mixer (Super Mixer SMV; manufactured by Kawata MFG. Co., Ltd.). The block copolymer hydrogenated product [D], which had been externally lubricated, was supplied to a weighing hopper of a twin screw kneading machine (TEM-37B; manufactured by Shibaura Machinery Co., Ltd.), and melted and kneaded at a screw barrel temperature of 220°C and at a screw rotation speed of 150 rpm for a residence time of 90 seconds. Strand was taken out and was pelletized by a pelletizer (fan cutter; manufactured by Kabushiki Kaisha Hoshi Plastic) while being cooled in a water bath. As a result, an alkoxysilyl group-modified product [S1] (silane-modified SIS block copolymer hydrogenated product) was prepared.

The obtained alkoxysilyl group-modified product [S1] was subjected to ¹H-NMR spectrometry. As a result, it was confirmed that the vinyltrimethoxysilane was bonded to the polymer.

In the FT-IR spectrum of the alkoxysilyl group-modified product [S1], new absorption bands derived from the Si-OCH₃ group at 1090 cm⁻¹ and derived from the Si-CH₂ group at 825 cm⁻¹ and 739 cm⁻¹ were observed at positions different from those derived from the Si-OCH₃ group and the Si-CH group of vinyltrimethoxysilane (1075 cm⁻¹, 808 cm⁻¹, and 766 cm⁻¹).

¹H-NMR spectrum of the alkoxysilyl group-modified product [S1] was measured (in deuterochloroform), and a peak based on protons of the methoxy group was observed at 3.6 ppm.

### [Example 1]

### (Production of composition)

A dispersion liquid of a perovskite-type quantum dot material was prepared by the following procedure.

FAPbBr₃, a quantum dot with the perovskite-type crystal structure, was produced using a known ligand assisted re-precipitation method (LARP method). Specifically, NHCH₂Br, PbBr₂, oleic acid, and octylamine were dissolved in N-methylpyrrolidone (NMP) to obtain a precursor solution. The obtained precursor solution was dropped into toluene, and FAPbBr₃ formed in the lower layer was collected by a centrifugal separation treatment. FAPbBr₃ thus collected was subjected to XRD measurement, and peaks in the spectrum derived from the perovskite-type crystal structure were confirmed as shown in FIG. 1.

FAPbBr₃ thus obtained was dispersed in toluene to obtain a dispersion liquid of the quantum dot material with a concentration of 2 mg/ml (2 kg/m³).

Subsequently, the olefin polymer (HSIS) produced in Production Example 2 was dissolved in cyclohexane as an organic solvent to prepare a solution (polymer solution). The concentration of the olefin polymer in the polymer solution was 25%.

A composition was obtained by mixing the above-mentioned dispersion liquid of the quantum dot material and the polymer solution such that the quantum dot material was included in an amount of 0.26 parts relative to 100 parts of the olefin polymer.

### (Production of film)

The obtained composition was applied onto a glass substrate using a spin coating method to form a composition layer. After that, the obtained composition layer was allowed to stand in a dark room in an environment of room temperature (about 20°C) for 24 hours to remove the solvent and the dispersion medium, thereby producing a film of about 600 µm.

### [Example 2]

A composition and a film were produced by the same manner as that of Example 1 except that the olefin polymer (SIS) produced in Production Example 1 was used instead of the olefin polymer (HSIS) produced in Production Example 2.

### [Example 3]

A composition and a film were produced by the same manner as that of Example 1 except that the olefin polymer (Si-HSIS) produced in Production Example 3 was used instead of the olefin polymer (HSIS) produced in Production Example 2.

### [Example 4]

A composition and a film were produced by the same manner as that of Example 1 except that a norbornene-based polymer ("ZEONOR" manufactured by ZEON Corporation, glass transition temperature: 140°C), which is a sort of cycloolefin polymer, was used instead of the olefin polymer (SIS) produced in Production Example 1, the concentration of the olefin polymer in the polymer solution was set to 10%, and the blending amount of the quantum dot material relative to 100 parts of the olefin polymer was set to 0.11 part.

### [Comparative Example 1]

A composition and a film were produced by the same manner as that of Example 1 except that an acrylic polymer (polymethyl methacrylate polymer: PMMA) (manufactured by Toyo Polymer Co., Ltd., "RUBYLON P") was used instead of the olefin polymer (SIS) produced in Production Example 1.

### [Comparative Example 2]

A dispersion liquid of a core-shell type quantum dot material was prepared by the following procedure.

A core-shell type quantum dot material (CdSe/Zn) manufactured by Sigma-Aldrich Co. LLC was dispersed in toluene to obtain a dispersion liquid of a quantum dot material having a concentration of 2 mg/ml (2 kg/m³).

A composition and a film were prepared by the same manner as that of Example 1 except that the dispersion liquid of the quantum dot material described above was used instead of the dispersion liquid of the quantum dot material obtained in Example 1.

### [Comparative Example 3]

A composition and a film were prepared by the same manner as that of Example 4 except that the dispersion liquid of the quantum dot material described above was used instead of the dispersion liquid of the quantum dot material obtained in Example 1.

The compositions and films obtained according to Examples 1 to 4 and Comparative Examples 1 to 3 were evaluated by the evaluation method described above. The results are shown in Table 1.

Abbreviations in the table indicate the following meanings.
"SIS": Cyclic olefin-based polymer produced according to Production Example 1
"HSIS": Cyclic olefin-based polymer produced according to Production Example 2
"Si-HSIS": Cyclic olefin-based polymer produced according to Production Example 3
"COP": Norbornene-based polymer
"PMMA": Acrylic polymer (polymethyl methacrylate polymer)
Blending amount (part): ratio of quantum dot material relative to 100 parts of polymer

**Table 1**

| | Composition | | | Evaluation | | | |
|---|---|---|---|---|---|---|---|
| | Poly mer | Quantum dot material | Blend ing amount (parts) | Atmos pheric stabi lity | Disper sibi lity | Lumi nous effici ency | Adhe sion |
| Ex. 1 | HSIS | Perovskite-type QD material (FAPBr₃) | 0.26 | A | A | A | C |
| Ex. 2 | SIS | Perovskite-type QD material (FAPBr₃) | 0.26 | B | A | A | C |
| Ex. 3 | Si-HSIS | Perovskite-type QD material (FAPBr₃) | 0.26 | A | A | A | A |
| Ex. 4 | COP | Perovskite-type QD material (FAPBr₃) | 0.11 | A | B | A | C |
| Comp. Ex. 1 | PMMA | Perovskite-type QD material (FAPBr₃) | 0.26 | C | A | A | B |
| Comp. Ex. 2 | HSIS | Core-shell type QD material (CdSe/ZnS) | 0.26 | B | A | C | C |
| Comp. Ex. 3 | COP | Core-shell type QD material (CdSe/ZnS) | 0.11 | B | C | C | C |

In Examples 1 to 4, it was confirmed that the atmospheric stability of the perovskite-type quantum dot material can be improved. On the other hand, as shown in Comparative Example 1, when the acrylic polymer was used in combination with the perovskite-type quantum dot material, sufficient atmospheric stability was not obtainable.

Furthermore, it was confirmed as shown in Comparative Examples 2 and 3 that, when the olefin polymer and the core-shell type quantum dot material were used in combination, the luminous efficiency and the atmospheric stability were lower than those of Examples 1 and 4.

## Claims

1. A composition comprising:
a quantum dot material having a perovskite-type crystal structure; and
an olefin polymer.

2. The composition according to claim 1, wherein the olefin polymer includes a cyclic olefin-based polymer.

3. The composition according to claim 2, wherein:
the cyclic olefin-based polymer includes a norbornene-based polymer; and
the norbornene-based polymer includes at least one type selected from a hydrogenated product of a ring-opening polymer of a monomer having a norbornene structure, and an addition copolymer of a monomer having a norbornene structure and an α-olefin and a hydrogenated product of the addition copolymer.

4. The composition according to claim 2, wherein:
the cyclic olefin-based polymer includes a hydrogenated block copolymer [E]; and
the hydrogenated block copolymer [E] is a hydrogenated block copolymer obtained by hydrogenating a block copolymer [D], the block copolymer [D] including
a polymer block [A] containing, as a main component, a repeating unit [I] derived from an aromatic vinyl compound, and
a polymer block [B] or a polymer block [C], the polymer block [B] containing, as main components, the repeating unit [I] derived from an aromatic vinyl compound and a repeating unit [II] derived from a chain conjugated diene compound, the polymer block [C] containing, as a main component, the repeating unit [II] derived from a chain conjugated diene compound.

5. The composition according to claim 4, wherein the cyclic olefin-based polymer contains an alkoxysilyl group.

6. The composition according to claim 1, wherein the olefin polymer includes a block copolymer [D], the block copolymer [D] including
a polymer block [A] containing, as a main component, a repeating unit [I] derived from an aromatic vinyl compound, and
a polymer block [B] or a polymer block [C], the polymer block [B] containing, as main components, the repeating unit [I] derived from an aromatic vinyl compound and a repeating unit [II] derived from a chain conjugated diene compound, the polymer block [C] containing, as a main component, the repeating unit [II] derived from a chain conjugated diene compound.

7. The composition according to claim 1, wherein an amount of the quantum dot material included in the composition is 0.05 part by weight or more and 50 parts by weight or less relative to 100 parts by weight of the olefin polymer.

8. A film comprising the composition according to any one of claims 1 to 7.

9. A light-emitting device using the film according to claim 8 as a light conversion element.

10. A power generation device using the film according to claim 8 as a power generation element.

11. A display body using the film according to claim 8 as a light conversion element.

12. A method for producing the composition according to any one of claims 1 to 7, the method comprising:
a first step of obtaining a dispersion liquid of the quantum dot material;
a second step of obtaining a solution of the olefin polymer; and
a third step of mixing the dispersion liquid of the quantum dot material and the solution of the olefin polymer.

13. A method for producing the composition according to any one of claims 1 to 7, the method comprising:
a first step of obtaining a dispersion liquid of the quantum dot material; and
a fourth step of adding the olefin polymer to the dispersion liquid and dissolving the polymer in the dispersion liquid.

14. A method for producing a film using the composition according to any one of claims 1 to 7, the method comprising:
a fifth step of forming a composition layer using the composition; and
a sixth step of drying the composition layer.

15. The method for producing a film according to claim 14, wherein:
the fifth step is a step of forming the composition layer by applying the composition onto a substrate; and
the application of the composition is performed using a die coater, a gravure coater, a comma coater, a knife coater, or inkjet.
